# EUROPEAN PATENT SPECIFICATION

(11) **EP 1 643 298 B1**
(45) Date of publication and mention of the grant of the patent: **31.10.2007**
(21) Application number: 05256112.3
(22) Date of filing: 29.09.2005
(51) Int. Cl.: G02F 1/1337, G02F 1/133, G03F 7/20, G02F 1/139

(54) **Method of manufacturing a liquid crystal display and a mask for use in same**
Verfahren zur Herstellung einer Flüssigkristallanzeige und Maske zur Verwendung darin
Procédé de fabrication d'un écran à cristaux liquides et masque à utiliser dans celui-ci

(30) Priority: 01.10.2004 KR 2004078338
(43) Date of publication of application: 05.04.2006
(73) Proprietor: Samsung Electronics Co., Ltd., Suwon-si, Gyeonggi-Do (KR)
(72) Inventor: Kim, Soo-jin, Suwon-si Gyeonggi-do (KR)
(74) Representative: Greene, Simon Kenneth

(56) References cited:
- EP-A- 0 499 944
- US-A- 5 486 403
- US-A- 5 830 605
- US-A1- 2004 075 791
- US-A1- 2005 162 598
- US-B1- 6 188 457
- US-B1- 6 362 863

## Description

### BACKGROUND OF THE INVENTION

### (a) Technical Field

The present disclosure relates to a method of manufacturing a liquid crystal display and a mask for use in same, and more particularly to a method of manufacturing a liquid crystal display including forming a slope member using the mask.

### (b) Discussion of the Related Art

A liquid crystal display (LCD) is a widely used flat panel display. An LCD includes two panels comprising field-generating electrodes such as pixel electrodes and a common electrode. A liquid crystal (LC) layer is interposed between the field generating electrodes. The LCD displays images by applying voltages to the field-generating electrodes to generate an electric field in the LC layer, which determines orientations of LC molecules in the LC layer to adjust polarization of incident light.

A vertical alignment (VA) mode LCD aligns LC molecules such that the long axes of the LC molecules are perpendicular to the panels in absence of electric field. The VA mode LCD has a high contrast ratio and a wide reference viewing angle. The wide reference viewing angle is defined as a viewing angle making the contrast ratio equal to about 1:10 or as a limit angle for the inversion in luminance between the grays.

The wide viewing angle of the VA mode LCD can be realized by cutouts in the field-generating electrodes and protrusions on the field-generating electrodes. Since the cutouts and the protrusions affect the tilt directions of the LC molecules, the tilt directions can be distributed into several directions by using the cutouts and the protrusions. Thus, the reference viewing angle is widened by using the cutouts and the protrusions.

The LCDs having the cutouts or the protrusions may have a large response time. The tilt directions of the liquid crystal molecules far from the cutouts and the protrusions are determined by pushing of the liquid crystal molecules on the field-generating electrodes or by collision with them. Thus the alignment of the liquid crystal molecules is unstable and irregular. Although the response time may be improved by closely spacing the cutouts, it may cause a decrease of the aperture ratio.

The LCD is manufactured by patterning several conductive layers and insulating layers using lithography and etching with masks. The lithography forms photoresist patterns using the masks. The layers are etched using the photoresist patterns as etch masks. Such masks have transparent areas and opaque areas for selectively transmitting exposure light. The photoresist patterns and the patterned layers have various shapes depending on the sizes and the shapes of the transparent areas and the opaque areas. Accordingly, a mask providing reproductivity and uniformity and having appropriate process margins is desired.

US 6,188,457 describes a liquid crystal display having opposed substrates and a tilted structure on one of the substrates. A mask is used to form the tilted structures by a single exposure. The mask comprises a plurality of light shielding members which are arranged such that in a first major exposure region the width of the light shielding members is encreasing along a predetermined direction, while the width of the slits formed between adjacent light shielding members is decreasing in said direction, and in a second major exposure region it is vice versa.

US 2004/0075791 describes a liquid crystal display having a patterned bottom electrode.

### SUMMARY OF THE INVENTION

According to an embodiment of the present invention, a mask for use in manufacturing a liquid crystal display includes an exposure area having transmittance that gradually increases along a predetermined direction as set out in claim 1.

Each of the first light blocking members and each of the second slits may have a width ranging from about 1.0 microns to about 2.5 microns.

A method of manufacturing a liquid crystal display panel according to an embodiment of the present invention is set out in claim 4.

The insulating layer may have photosensitivity.

Each of the first light blocking members and each of the second slits may have a width ranging from about 1.0 microns to about 2.5 microns.

The slope member may have a flat inclined surface having a single gradient.

The method may further include forming a gate line, a data line, a thin film transistor, and a pixel electrode before the formation of the slope member.

The method may further include forming a common electrode before the formation of the slope member.

The pixel electrode and/or the common electrode may include a cutout.

### BRIEF DESCRIPTION OF THE DRAWINGS

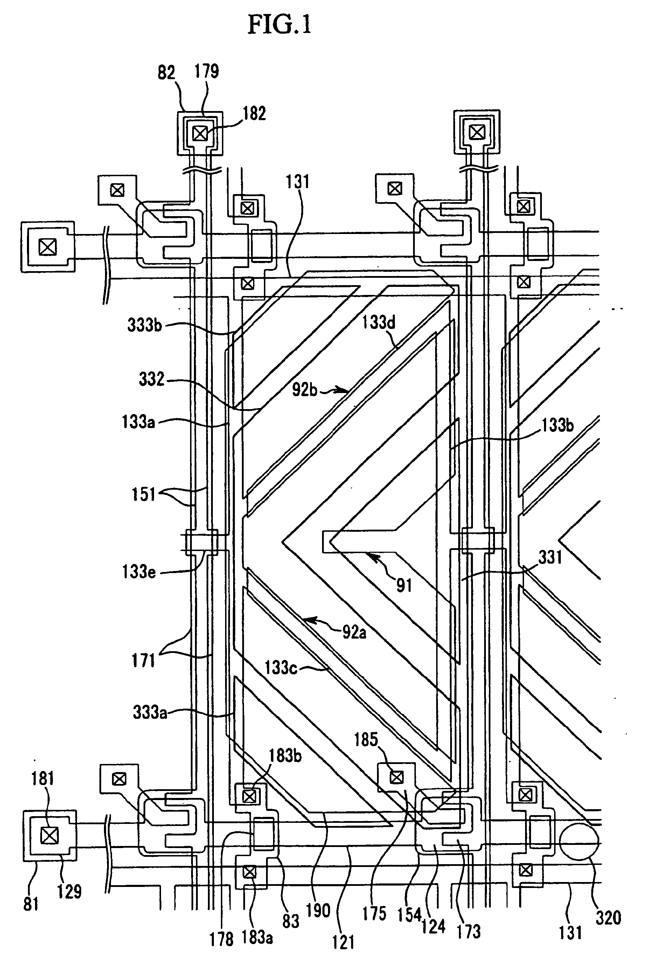

Preferred embodiments of the present disclosure can be understood in more detail from the following description taken in conjunction with the accompanying drawings in which: Fig. 1 is a layout view of a TFT array panel of an LCD according to an embodiment of the present invention;
Fig. 2 is a layout view of a common electrode panel of an LCD according to an embodiment of the present invention;
Fig. 3 is a layout view of an LCD including the TFT array panel shown in Fig. 1 and the common electrode panel shown in Fig. 2 according to an embodiment of the present invention;
Fig. 4 is a sectional view of the LCD shown in Fig. 3 taken along the line IV-IV';
Fig. 5 is a layout view of an LCD according to an embodiment of the present invention;
Fig. 6 is a sectional view of the LCD shown in Fig. 5 taken along the line VII-VII';
Fig. 7 is a layout view of an LCD according to an embodiment of the present invention;
Fig. 8 is a sectional view of the LCD shown in Fig. 7 taken along the line Vlll-VIII';
Fig. 9 is a table illustrating measured response time of liquid crystal for slope members having various inclination angles;
Fig. 10 is a sectional view of a common electrode panel and a mask for forming slope members in an intermediate step of a manufacturing method of an LCD according to an embodiment of the present invention; and
Fig. 11 illustrates slits of the mask aligned with a slope member according to an embodiment of the present invention.

### DETAILED DESCRIPTION OF EMBODIMENTS

Preferred embodiments of the present invention will be described below in more detail with reference to the accompanying drawings. The present invention may, however, be embodied in many different forms and should not be construed as limited to the embodiments set forth herein.

An LCD according to an embodiment of the present invention will be described with reference to Figs. 1-4.

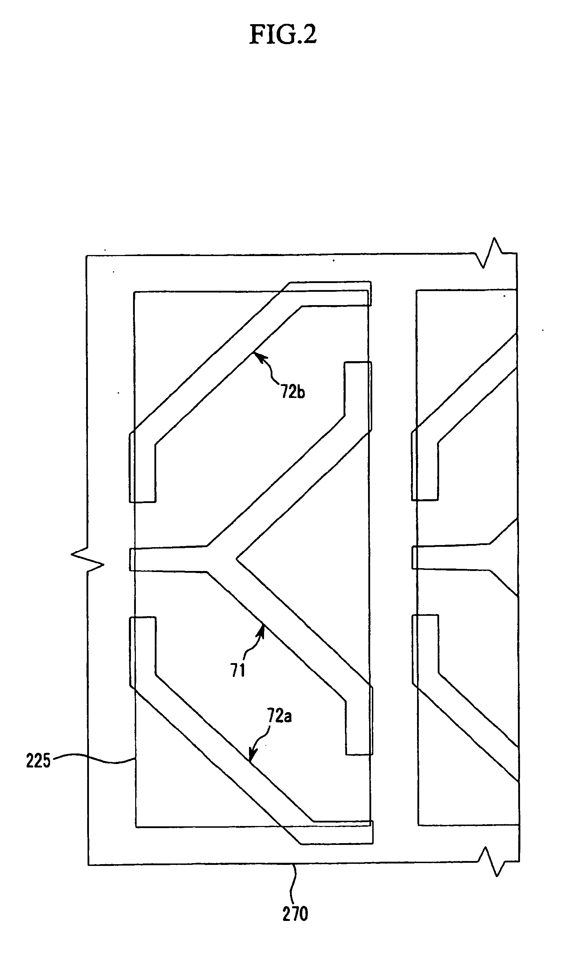

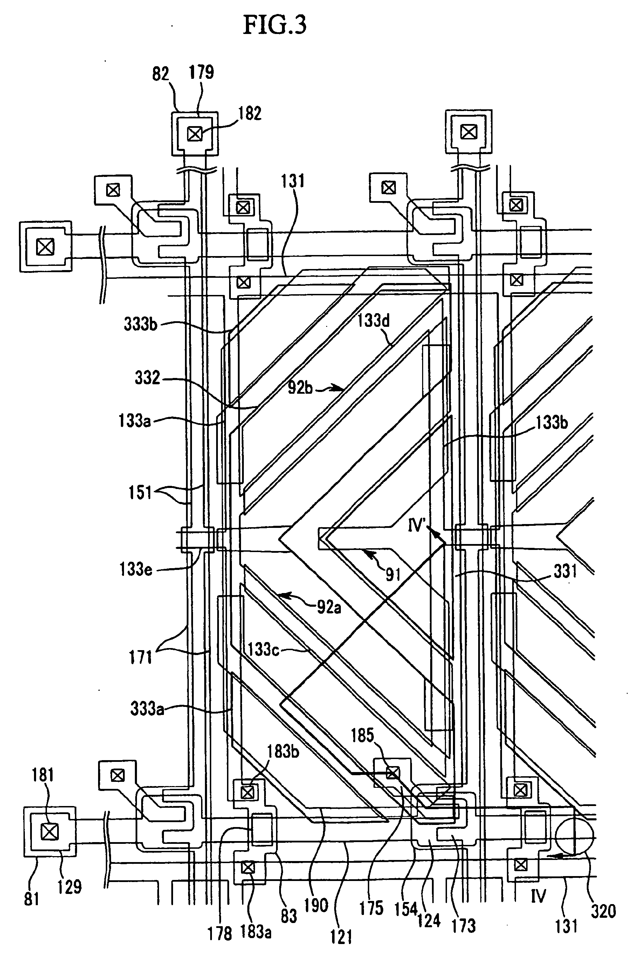

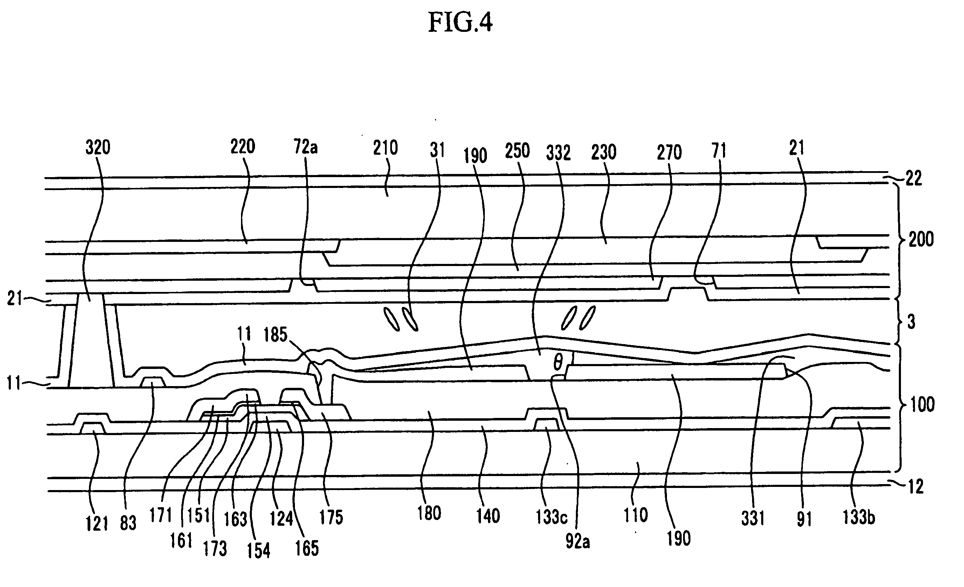

Fig. 1 is a layout view of a TFT array panel of an LCD according to an embodiment of the present invention. Fig. 2 is a layout view of a common electrode panel of an LCD according to an embodiment of the present invention. Fig. 3 is a layout view of an LCD including the TFT array panel shown in Fig. 1 and the common electrode panel shown in Fig. 2. Fig. 4 is a sectional view of the LCD shown in Fig. 3 taken along the line IV-IV'.

An LCD according to an embodiment of the present invention includes a TFT array panel 100, a common electrode panel 200, and an LC layer 3 interposed between the TFT array panel 100 and the common electrode panel 200.

The TFT array panel 100 is described with reference to Figs. 1, 3 and 4. A plurality of gate lines 121 and a plurality of storage electrode lines 131 are formed on a substrate 110 comprising an insulating material such as transparent glass or plastic. The gate lines 121 transmit gate signals and extend substantially in a transverse direction. Each gate line 121 includes a plurality of gate electrodes 124 protruding upwardly and downwardly and an end portion 129 having an area for contacting another layer or an external driving circuit. A gate driving circuit (not shown) for generating the gate signals may be mounted on a flexible printed circuit (FPC) film (not shown). The FPC film may be attached to the substrate 110, directly mounted on the substrate 110, or integrated onto the substrate 110. The gate lines 121 may extend to be connected to a driving circuit that may be integrated on the TFT array panel 100.

The storage electrode lines 131 are supplied with a predetermined voltage. Each storage electrode line 131 includes a stem extending substantially parallel to the gate lines 121, a plurality of branches 133a-133d, and a plurality of connections 133e connecting the branches 133a-133d. Each storage electrode line 131 is disposed between two adjacent gate lines 121. The stem is close to an upper gate line 121 of the two adjacent gate lines 121.

A set of branches 133a-133d includes two longitudinal branches forming first and second storage electrodes 133a and 133b and spaced apart from each other and two oblique branches forming third and fourth storage electrodes 133c and 133d. The third and fourth electrodes 133c and 134d are connected between the first and the second storage electrodes 133a and 133b. The first storage electrode 133a has a free end portion including a projection and a fixed end portion that is connected to the storage electrode line 131. The third and the fourth storage electrodes 133c and 133d extend approximately from a center of the first storage electrode 133a to lower and upper ends of the second storage electrode 133b, respectively.

Each of the connections 133e is connected between a first storage electrode 133a of a set of storage electrodes 133a-133d and a second storage electrode 133b of another set of storage electrodes 133a-133d adjacent thereto.

According to embodiments of the present invention, the storage electrode lines 131 may have various shapes and arrangements.

The gate lines 121 and the storage electrode lines 131 may comprise Al containing metal such as Al and Al alloy, Ag containing metal such as Ag and Ag alloy, Cu containing metal such as Cu and Cu alloy, Mo containing metal such as Mo and Mo alloy, Cr, Ta, or Ti. According to an embodiment of the present invention, the gate lines 121 and the storage electrode lines 131 may have a multi-layered structure including two conductive films (not shown) having different physical characteristics. One of the two films may comprise low resistivity metal including Al containing metal, Ag containing metal, and Cu containing metal for reducing a signal delay or a voltage drop. The other film may comprise a material such as Mo containing metal, Cr, Ta, or Ti, which has good physical, chemical, and electrical contact characteristics with other materials such as indium tin oxide (ITO) or indium zinc oxide (IZO). Examples of the combination of the two films are a lower Cr film and an upper Al (alloy) film and a lower Al (alloy) film and an upper Mo (alloy) film. According to an embodiment of the present invention, the gate lines 121 and the storage electrode lines 131 may comprise various metals or conductors.

The lateral sides of the gate lines 121 and the storage electrode lines 131 are inclined relative to a surface of the substrate 110. The inclination angle thereof ranges from about 20 degrees to about 80 degrees.

A gate insulating layer 140 comprising silicon nitride (SiNx) or silicon oxide (SiOx) is formed on the gate lines 121 and the storage electrode lines 131.

A plurality of semiconductor stripes 151 comprising hydrogenated amorphous silicon ("a-Si") or polysilicon are formed on the gate insulating layer 140. Each semiconductor stripe 151 extends substantially in the longitudinal direction and becomes wide near the gate lines 121 and the storage electrode lines 131 such that the semiconductor stripes 151 cover large areas of the gate lines 121 and the storage electrode lines 131. Each semiconductor stripe 151 has a plurality of projections 154 branched out toward the gate electrodes 124.

A plurality of ohmic contact stripes 161 and ohmic contact islands 165 are formed on the semiconductor stripes 151. The ohmic contact stripes 161 and the ohmic contact islands 165 may comprise n+ hydrogenated a-Si heavily doped with n-type impurity such as phosphorous. Alternatively, the ohmic contact stripes 161 and the ohmic contact islands 165 may comprise silicide. Each ohmic contact stripe 161 has a plurality of projections 163. The projections 163 and the ohmic contact islands 165 are located in pairs on the projections 154 of the semiconductor stripes 151.

The lateral sides of the semiconductor stripes 151 and the ohmic contacts 161 and 165 are inclined relative to the surface of the substrate 110, and the inclination angles thereof may be in a range from about 30 degrees to about 80degrees.

A plurality of data lines 171, a plurality of drain electrodes 175, and a plurality of isolated metal pieces 178 are formed on the ohmic contacts 161 and 165 and the gate insulating layer 140.

The data lines 171 transmit data signals and extend substantially in the longitudinal direction to intersect the gate lines 121 and the stems and the connections 133e of the storage electrode lines 131. Each data line 171 includes a plurality of source electrodes 173 projecting toward the gate electrodes 124 and an end portion 179 having an area for contacting another layer or an external driving circuit. A data driving circuit (not shown) for generating the data signals may be mounted on an FPC film (not shown). The FPC film may be attached to the substrate 110, directly mounted on the substrate 110, or integrated onto the substrate 110. The data lines 171 may extend to be connected to a driving circuit that may be integrated on the TFT array panel 100.

Each drain electrode 175 includes a wide end portion and a narrow end portion. The narrow end portion is partially enclosed by a source electrode 173 that is curved.

A gate electrode 124, a source electrode 173, and a drain electrode 175 along with a projection 154 of a semiconductor stripe 151 form a TFT having a channel formed in the projection 154 disposed between the source electrode 173 and the drain electrode 175.

The metal pieces 178 are disposed on the gate lines 121 near the end portions of the first storage electrodes 133a.

The data lines 171, the drain electrodes 175, and the metal pieces 178 comprise refractory metal such as Cr, Mo, Ta, Ti, or alloys thereof. Alternatively, the data lines 171, the drain electrodes 175, and the metal pieces 178 may comprise various metals or conductors. According to an embodiment of the present invention, the data lines 171, the drain electrodes 175, and the metal pieces 178 may have a multilayered structure including a refractory metal film (not shown) and a low resistivity film (not shown). Examples of the multi-layered structure are a double-layered structure including a lower Cr/Mo (alloy) film and an upper Al (alloy) film and a triple-layered structure of a lower Mo (alloy) film, an intermediate Al (alloy) film, and an upper Mo (alloy) film.

The data lines 171, the drain electrodes 175, and the metal pieces 178 have inclined edge profiles, and the inclination angles thereof range from about 30 degrees to about 80 degrees.

The ohmic contacts 161 and 165 are interposed between the underlying semiconductor stripes 151 and the overlying conductors 171 and 175 thereon and reduce the contact resistance therebetween. Although the semiconductor stripes 151 are narrower than the data lines 171 at most places, the width of the semiconductor stripes 151 becomes large near the gate lines 121 to smooth the profile of the surface, thereby preventing the disconnection of the data lines 171. The projections 154 of the semiconductor stripes 151 include some exposed portions, which are not covered with the data lines 171, the drain electrodes 175, and the metal pieces 178. The exposed portions include portions located between the source electrodes 173 and the drain electrodes 175.

A passivation layer 180 is formed on the data lines 171, the drain electrodes 175, the metal pieces 178, and the exposed portions of the semiconductor stripes 151. The passivation layer 180 may comprise an inorganic or organic insulator. The passivation layer 180 may have a flat top surface. Examples of an inorganic insulator include silicon nitride and silicon oxide. An organic insulator may have photosensitivity and a dielectric constant less than about 4.0. The passivation layer 180 may include a lower film of an inorganic insulator and an upper film of an organic insulator to have good insulating characteristics of the organic insulator while preventing the exposed portions of the semiconductor stripes 151 from being damaged by the organic insulator.

The passivation layer 180 has a plurality of contact holes 182 and 185 exposing the end portions 179 of the data lines 171 and the drain electrodes 175, respectively. The passivation layer 180 and the gate insulating layer 140 have a plurality of contact holes 181 exposing the end portions 129 of the gate lines 121, a plurality of contact holes 183a exposing portions of the storage electrode lines 131 near the fixed end portions of the first storage electrodes 133a, and a plurality of contact holes 183b exposing the projections of the free end portions of the first storage electrodes 133a.

A plurality of pixel electrodes 190, a plurality of overpasses 83, and a plurality of contact assistants 81 and 82 are formed on the passivation layer 180 and may comprise a transparent conductor such as ITO or IZO or a reflective conductor such as Ag, Al, Cr, or alloys thereof.

The pixel electrodes 190 are physically and electrically connected to the drain electrodes 175 through the contact holes 185 such that the pixel electrodes 190 receive the data voltages from the drain electrodes 175. The pixel electrodes 190 supplied with the data voltages generate electric fields in cooperation with the common electrode 270 of the common electrode panel 200. The generated electric fields determine the orientations of liquid crystal molecules 31 in the liquid crystal layer 3. A pixel electrode 190 and the common electrode 270 form a capacitor referred to as a "liquid crystal capacitor," which stores applied voltages after the TFT turns off.

A pixel electrode 190 overlaps a storage electrode line 131 including storage electrodes 133a-133d. The pixel electrode 190 and a drain electrode 175 connected thereto and the storage electrode line 131 form an additional capacitor referred to as a "storage capacitor," which enhances the voltage storing capacity of the liquid crystal capacitor.

Each pixel electrode 190 is approximately a rectangle shape having chamfered left corners. The chamfered edges of the pixel electrode 190 make an angle of about 45 degrees with the gate lines 121.

Each pixel electrode 190 has a center cutout 91, a lower cutout 92a, and an upper cutout 92b, which divide the pixel electrode 190 into a plurality of partitions. The cutouts 91-92b substantially have an inversion symmetry with respect to an imaginary transverse line bisecting the pixel electrode 190.

The lower and the upper cutouts 92a and 92b obliquely extend from a right edge of the pixel electrode 190 near right corners approximately to a center of a left edge of the pixel electrode 190. The lower and the upper cutouts 92a and 92b overlap the third and the fourth storage electrodes 133c and 133d, respectively. The lower and the upper cutouts 92a and 92b are disposed at lower and upper halves of the pixel electrode 190, respectively, which can be divided by the imaginary transverse line. The lower and the upper cutouts 92a and 92b make an angle of about 45 degrees to the gate lines 121, and extend substantially perpendicular to each other.

The center cutout 91 extends along the imaginary transverse line and includes an inlet from the right edge of the pixel electrode 190, which has a pair of inclined edges substantially parallel to the lower cutout 92a and the upper cutout 92b, respectively.

Accordingly, the lower half of the pixel electrode 190 is partitioned into two partitions by the lower cutout 92a, and the upper half of the pixel electrode 190 is also partitioned into two partitions by the upper cutout 92b. The number of partitions or the number of the cutouts is varied depending on design factors such as, for example, the size of pixels, the ratio of the transverse edges and the longitudinal edges of the pixel electrode 190, and the type and characteristics of the liquid crystal layer 3.

The contact assistants 81 and 82 are connected to the end portions 129 of the gate lines 121 and the end portions 179 of the data lines 171 through the contact holes 181 and 182, respectively. The contact assistants 81 and 82 protect the end portions 129 and 179 and enhance the adhesion between the end portions 129 and 179 and external devices.

The overpasses 83 cross over the gate lines 121. The overpasses 83 are connected to the exposed portions of the storage electrode lines 131 and the exposed projection of the free end portions of the first storage electrodes 133a through the contact holes 183a and 183b, respectively. The contact holes 183a and 183b are disposed opposite each other with respect to the gate lines 121. The overpasses 83 overlap the metal pieces 178. The overpasses 83 may be electrically connected to the metal pieces 178. The storage electrode lines 131, including the storage electrodes 133a-133d and the connections 133e, the overpasses 83 and the metal pieces 178 are used for repairing defects in the gate lines 121, the data lines 171, or the TFTs. The electrical connection between the gate lines 121 and the storage electrode lines 131 for repairing the gate lines 121 is obtained by illuminating cross points of the gate lines 121 and the overpasses 83 by a laser beam to electrically connect the gate lines 121 to the overpasses 83. The metal pieces 178 enhance the electrical connection between the gate lines 121 and the overpasses 83.

A plurality of sets of slope members 331, 332, 333a and 333b are formed on the pixel electrodes 190 and the passivation layer 180. The slope members 331, 332, 333a and 333b may comprise an insulator that has a dielectric constant preferably equal to or lower than a dielectric constant of the LC layer 3.

Each set of the slope members 331-333b includes four slope members 331-333b disposed on a pixel electrode 190. Each of the slope members 331-333b has a planar trapezoid, triangle, or chevron shape including two primary edges and two secondary edges. The primary edges of the slope members 331-333b are parallel to edges of the cutouts 91-92b and the chamfered left edges of the pixel electrode 190. The primary edges of the slope members 331-333b are disposed between the cutouts 91-92b or between the cutouts 92a and 92b and the chamfered left edges of the pixel electrode 190. The secondary edges of the slope members 331, 332, 333a and 333b are parallel to the gate lines 121 or the data lines 171.

Each of the slope members 331-333b has a ridge and inclined surfaces. The ridge is disposed approximately on and extends along center lines of the cutouts 92a and 92b, on the edges of the cutout 91, or on the chamfered edges of the pixel electrode 190. The inclined surfaces have heights decreasing from the ridge to the primary edges. The height of the ridge is preferably in a range of about 0.5 microns to about 2.0 microns, and the inclination angle θ of the inclined surfaces relative to the surface of the substrate 110 may be smaller than about 45 degrees. According to an embodiment of the present invention, the inclination angle θ is in a range of about 1 to about 10 degrees or about 1.2 to about 3.0 degrees. The inclined surfaces may be straight or curved. The inclination angle of the curved surface can be defined as the average inclination angle or the gradient of a right triangle that is perpendicular to the ridge. The inclined surfaces have a lateral edge connecting a top and a lateral edge point of a slope member 331-333b.

According to an embodiment of the present invention, a set of the slope members 331-333b occupy an area equal to or larger than half of a pixel electrode 190. The slope members 331-333b for adjacent pixel electrodes 190 may be connected to each other.

The description of the common electrode panel 200 follows with reference to Figs. 2-4.

A light blocking member 220 referred to as a black matrix for preventing light leakage is formed on an insulating substrate 210 such as transparent glass or plastic. The light blocking member 220 may include a plurality of openings 225 that face the pixel electrodes 190 and may have substantially the same planar shape as the pixel electrodes 190. The light blocking member 220 may include linear portions corresponding to the data lines 171 and other portions corresponding to the TFTs.

A plurality of color filters 230 are formed on the substrate 210. The plurality of color filters 230 are disposed substantially in the openings 225 defined by the light blocking member 220. The color filters 230 may extend substantially in the longitudinal direction along the pixel electrodes 190. The color filters 230 may include one of the primary colors such as red, green and blue.

An overcoat 250 is formed on the color filters 230 and the light blocking member 220. The overcoat 250 prevents the color filters 230 from being exposed and provides a flat surface. In an embodiment of the present invention, the overcoat 250 may be omitted.

A common electrode 270 is formed on the overcoat 250. The common electrode 270 may comprise a transparent conductive material such as ITO and IZO and has a plurality of sets of cutouts 71, 72a and 72b.

A set of cutouts 71-72b face a pixel electrode 190 and include a center cutout 71, a lower cutout 72a, and an upper cutout 72b. Each of the cutouts 71-72b is disposed between adjacent cutouts 91-92b of the pixel electrode 190 or between a cutout 92a or 92b and a chamfered edge of the pixel electrode 190. In addition, each of the cutouts 71-72b includes at least one oblique portion extending parallel to the lower cutout 92a or the upper cutout 92b of the pixel electrode 190. The cutouts 71-72b have substantially an inversion symmetry with respect to the above-described transverse line bisecting the pixel electrode 190.

Each of the lower and upper cutouts 72a and 72b includes an oblique portion extending approximately from a left edge of the pixel electrode 190 approximately to lower or upper edge of the pixel electrode 190. Each of the lower and upper cutouts 72a and 72b further includes transverse and longitudinal portions extending from respective ends of the oblique portion along edges of the pixel electrode 190, overlapping the edges of the pixel electrode 190, and making obtuse angles with the oblique portion.

The center cutout 71 includes a central transverse portion, a pair of oblique portions, and a pair of terminal longitudinal portions. The central transverse portion extends from the left edge of the pixel electrode 190 along the above-described transverse line. The pair of oblique portions extends from an end of the central transverse portion approximately to a right edge of the pixel electrode and makes oblique angles with the central transverse portion. The pair of the terminal longitudinal portions extends from the ends of the respective oblique portions along the right edge of the pixel electrode 190. The pair of the terminal longitudinal portions overlaps the right edge of the pixel electrode 190, and makes obtuse angles with the respective oblique portions.

The number of the cutouts 71-72b may be varied depending on the design factors. The light blocking member 220 may also overlap the cutouts 71-72b to block the light leakage through the cutouts 71-72b.

A plurality of columnar spacers 320 comprising, for example, an insulator are disposed between the TFT array panel 100 and the common electrode panel 200. The spacers 320 prop the TFT array panel 100 and the common electrode panel 200 such that the spacers 320 create a gap between the panels 100 and 200. The spacers 320 are disposed on the gate lines 121. Alternatively, the spacers 320 may be disposed on an area other than the gate lines 121. The spacers 320 may comprise the same layer as the slope members 331-333b or may be incorporated into the passivation layer 180.

Alignment layers 11 and 21 that may be homeotropic are coated on inner surfaces of the panels 100 and 200. Polarizers 12 and 22 are provided on outer surfaces of the panels 100 and 200 so that their polarization axes may be crossed and one of the polarization axes may be parallel to the gate lines 121. According to an embodiment of the present invention, one of the polarizers 12 and 22 may be omitted when the LCD is a reflective type LCD.

The LCD may further include at least one retardation film (not shown) for compensating for the retardation of the LC layer 3. The retardation film has birefringence and provides retardation opposite to that given by the LC layer 3.

The LCD may further include a backlight unit (not shown) supplying light to the LC layer 3 through the polarizers 12 and 22, the retardation film, and the panels 100 and 200.

The LC layer 3 may have negative dielectric anisotropy. The LC layer 3 may be subjected to a vertical alignment, such that the LC molecules 31 in the LC layer 3 are aligned such that their long axes are substantially vertical to the surfaces of the panels 100 and 200 in absence of an electric field. Accordingly, incident light cannot pass through the crossed polarizers 12 and 22.

Upon application of the common voltage to the common electrode 270 and a data voltage to the pixel electrodes 190, an electric field substantially perpendicular to the surfaces of the panels 100 and 200 is generated. Both the pixel electrodes 190 and the common electrode 270 are commonly referred to as field generating electrodes. The LC molecules 31 tend to change their orientations in response to the electric field such that their long axes are perpendicular to the field direction. The cutouts 91-92b and 71-72b, the edges of the pixel electrodes 190, and the slope members 331-333b control the tilt directions of the LC molecules 31 in the LC layer 3. The LC molecules 31 are pre-tilted by the slope members 331-333b in the absence of the electric field. The pre-tilt directions of the LC molecules 31 determine the tilt directions of the LC molecules 31 upon application of the electric field. The pre-tilt directions are substantially perpendicular to the edges of the cutouts 91-92b and the oblique edges of the pixel electrodes 190.

The cutouts 91-92b and 71-72b of the field generating electrodes 190 and 270 and the oblique edges of the pixel electrodes 190 distort the electric field to have a horizontal component. The horizontal component is substantially perpendicular to the edges of the cutouts 91-92b and 71-72b and the oblique edges of the pixel electrodes 190.

In addition, the thickness variance of the slope members 331-333b distorts the equipotential lines of the electric field. The distortion of the equipotential lines provides the tilting force, which also coincides with the tilt directions determined by the cutouts 91-92b and 71-72b when the dielectric constant of the slope members 331-333b is lower than the LC layer 3.

Accordingly, the tilt directions of the LC molecules 31 far from the cutouts 91-92b and 71-72b and the chamfered edges of the pixel electrodes 190 are also determined to reduce the response time of the LC molecules 31.

Referring to Fig. 3, a set of the cutouts 91-92b and 71-72b divides a pixel electrode 190 into a plurality of sub-areas. Each sub-area has two major edges. Since the LC molecules 31 on each sub-area tilt perpendicular to the major edges, the azimuthal distribution of the tilt directions are localized in four directions, thereby increasing the reference viewing angle of the LCD.

At least one of the cutouts 91-92b and 71-72b can be substituted with protrusions (not shown) or depressions (not shown). The protrusions may comprise an organic or inorganic material and be disposed on or under the field-generating electrodes 190 or 270.

The shapes and the arrangements of the cutouts 91-92b and 71-72b may be modified.

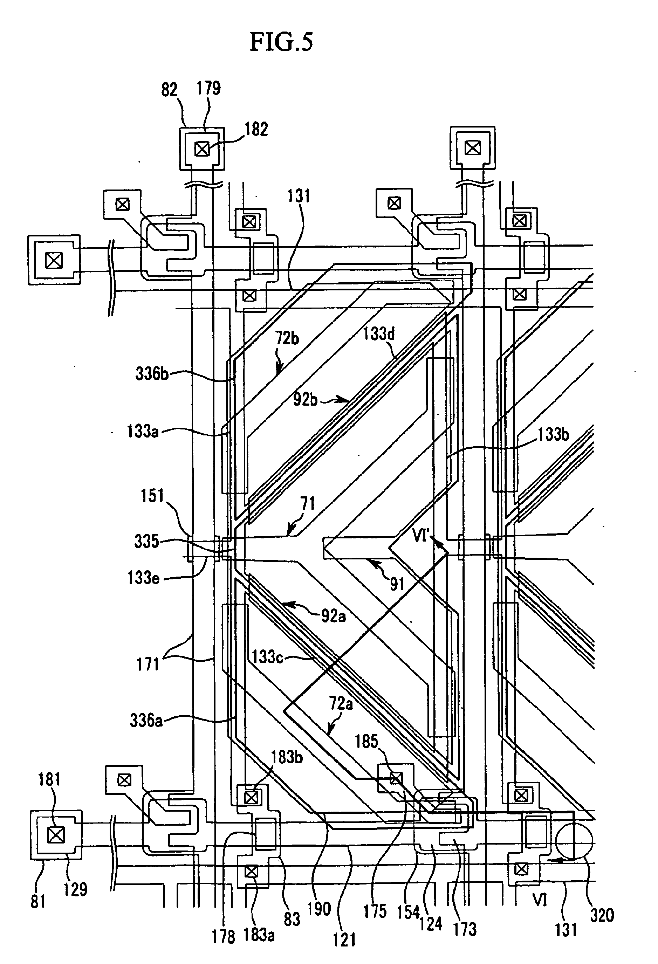

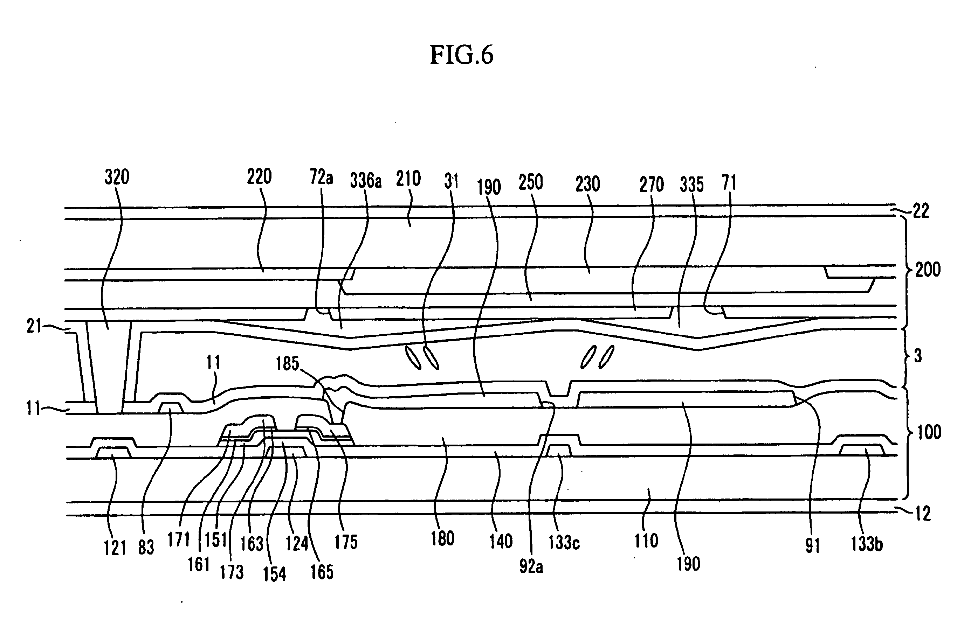

An LCD according to an embodiment of the present invention will be described with reference to Figs. 5 and 6.

Fig. 5 is a layout view of an LCD according to an embodiment of the present invention. Fig. 6 is a sectional view of the LCD shown in Fig. 5 taken along the line VII-VII'.

Referring to Figs. 5 and 6, an LCD includes a TFT array panel 100, a common electrode panel 200, an LC layer 3 and a plurality of columnar spacers 322 interposed between the panels 100 and 200, and a pair of polarizers 12 and 22 attached on outer surfaces of the panels 100 and 200.

Layered structures of the panels 100 and 200 according to this embodiment are substantially the same as those shown in Figs. 1-4.

Regarding the TFT array panel 100, a plurality of gate lines 121 including gate electrodes 124 and end portions 129 and a plurality of storage electrode lines 131 are formed on a substrate 110. A gate insulating layer 140, a plurality of semiconductor stripes 151including projections 154, and a plurality of ohmic contact stripes 161 including projections 163 and a plurality of ohmic contact islands 165 are sequentially formed thereon. A plurality of data lines 171 including source electrodes 173 and end portions 179, a plurality of drain electrodes 175, and a plurality of isolated metal pieces 178 are formed on the ohmic contacts 161 and 165, and a passivation layer 180 is formed thereon. A plurality of contact holes 181, 182, 183a, 183b and 185 are provided at the passivation layer 180 and the gate insulating layer 140. A plurality of pixel electrodes 190 having a plurality of cutouts 91-92b, a plurality of overpasses 83, and a plurality of contact assistants 81 and 82 are formed on the passivation layer 180, and an alignment layer 11 is coated thereon.

Regarding the common electrode panel 200, a light blocking member 220, a plurality of color filters 230, an overcoat 250, a common electrode 270 having a plurality of cutouts 71-72b, and an alignment layer 21 are formed on an insulating substrate 210.

The common electrode panel 200 includes a plurality of sets of slope members 335, 336a and 336b disposed on the common electrode 270 and the overcoat 250, while the TFT array panel 100 does not include a slope member. Similar to the slope members 331-333b, the slope members 335, 336a and 336b may comprise an insulator. Each set of the slope members 335-336b includes three slope members 335-336b facing a pixel electrode 190. Each of the slope members 335-336b includes a planar trapezoid or chevron shape having two primary edges and two secondary edges. The primary edges of the slope members 335-336b are parallel to oblique edges of the cutouts 71-72b. The primary edges of the slope members 335-336b are disposed opposite each other with respect to the cutouts 71-72b. The secondary edges of the slope members 335-336b are parallel to the gate lines 121 or the data lines 171. Each of the slope members 335-336b has a ridge and inclined surfaces. The ridge is disposed approximately on and extends along center lines of the oblique portions of the cutouts 71-72b. The inclined surfaces have heights decreasing from the ridge to the primary edges. The inclination angle θ of the inclined surfaces relative to the surface of the substrate 210 is in a range of about 1 to about 10 degrees.

In addition, the semiconductor stripes 151 of the TFT array panel 100 according to an embodiment have substantially the same planar shapes as the data lines 171, the drain electrodes 175, and the underlying ohmic contacts 161 and 165. The projections 154 of the semiconductor stripes 151 include some exposed portions, which are not covered with the data lines 171 and the drain electrodes 175. The exposed portion may include portions located between the source electrodes 173 and the drain electrodes 175.

The TFT array panel 100 further includes a plurality of semiconductor islands (not shown) and a plurality of ohmic contact islands (not shown) disposed thereon, which are disposed under the metal pieces 178.

A manufacturing method of the TFT array panel according to an embodiment of the present invention simultaneously forms the data lines 171, the drain electrodes 175, the metal pieces 178, the semiconductors 151, and the ohmic contacts 161 and 165 using one photolithography step.

A photoresist pattern for the photolithography process has position-dependent thickness. First and second portions of the photoresist pattern have a different thickness. For example, a thickness of the photoresist pattern decreases from the first portion to the second portion. The first portions are located on wire areas that are occupied by the data lines 171, the drain electrodes 175, and the metal pieces 178. The second portions are located on channel areas of TFTs.

The position-dependent thickness of the photoresist is obtained by several techniques, for example, by providing translucent areas on the exposure mask as well as transparent areas and light blocking opaque areas. The translucent areas may have a slit pattern, a lattice pattern, a thin film(s) with intermediate transmittance or an intermediate thickness. When using a slit pattern, the width of the slits or the distance between the slits may be smaller than the resolution of a light exposer used for the photolithography. Another example is to use a reflowable photoresist. Once a photoresist pattern comprising a reflowable material is formed by using a normal exposure mask with transparent areas and opaque areas, it is subject to a reflow process to flow onto areas without the photoresist, thereby forming thin portions.

As a result, the manufacturing process is simplified by omitting a photolithography step.

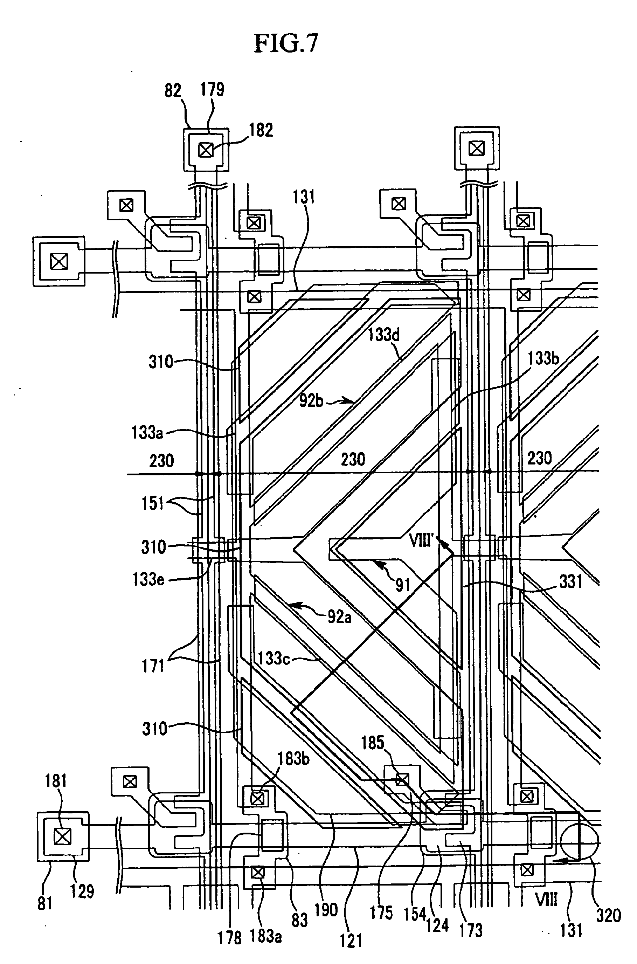

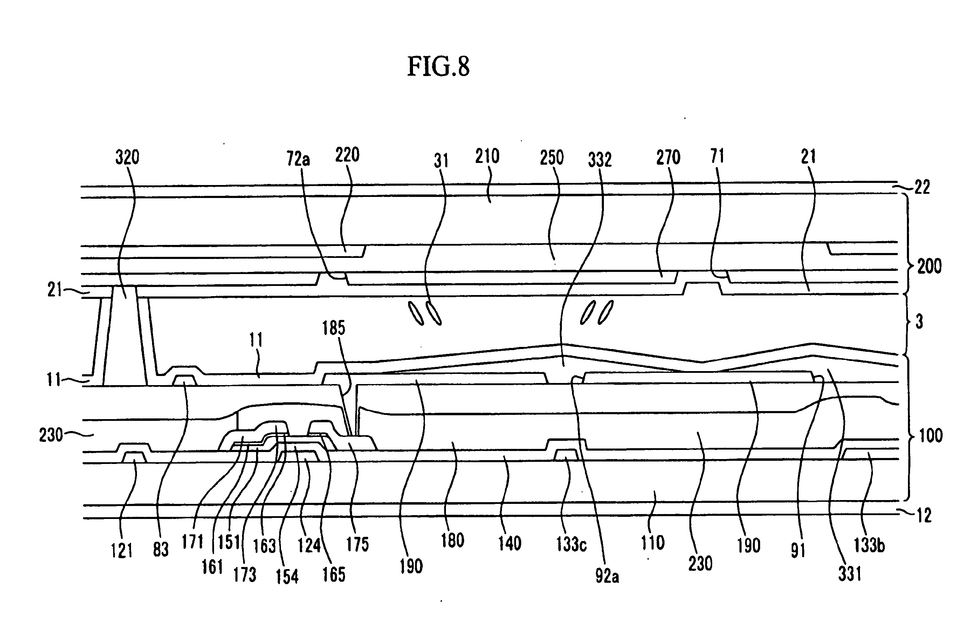

An LCD according to an embodiment of the present invention will be described with reference to Figs. 7 and 8.

Fig. 7 is a layout view of an LCD according to an embodiment of the present invention. Fig. 8 is a sectional view of the LCD shown in Fig. 7 taken along line VIII-VIII'.

Referring to Figs. 7 and 8, an LCD includes a TFT array panel 100, a common electrode panel 200, an LC layer 3 and a plurality of columnar spacers 320 interposed between the panels 100 and 200, and a pair of polarizers 12 and 22 attached to outer surfaces of the panels 100 and 200.

Layered structures of the panels 100 and 200 are substantially the same as those shown in Figs. 1-4.

Regarding the TFT array panel 100, a plurality of gate lines 121 including gate electrodes 124 and end portions 129 and a plurality of storage electrode lines 131 are formed on a substrate 110. A gate insulating layer 140, a plurality of semiconductor stripes 151 including projections 154, and a plurality of ohmic contact stripes 161 including projections 163 and a plurality of ohmic contact islands 165 are sequentially formed thereon. A plurality of data lines 171 including source electrodes 173 and end portions 179, a plurality of drain electrodes 175, and a plurality of isolated metal pieces 178 are formed on the ohmic contacts 161 and 165 and the gate insulating layer 140, and a passivation layer 180 is formed thereon. A plurality of contact holes 181, 182, 183a, 183b and 185 are provided at the passivation layer 180 and the gate insulating layer 140. A plurality of pixel electrodes 190 having a plurality of cutouts 91-92b, a plurality of overpasses 83, and a plurality of contact assistants 81 and 82 are formed on the passivation layer 180. A plurality of slope members 331-333b are formed on the pixel electrodes 190 and the passivation layer 180. An alignment layer 11 is coated thereon.

Regarding the common electrode panel 200, a light blocking member 220, an overcoat 250, a common electrode 270 including a plurality of cutouts 71-72b, and an alignment layer 21 are formed on an insulating substrate 210.

The TFT array panel 100 includes a plurality of color filter stripes 230 disposed under the passivation layer 180, while the common electrode panel 200 has no color filter. The color filter stripes 230 extend along a longitudinal direction and edges of two adjacent color filter stripes 230 match with each other on the data lines 171. According to an embodiment of the present invention, the color filter stripes 230 may overlap each other to block the light leakage between the pixel electrodes 190, or may be spaced apart from each other. When the color filter stripes 230 overlap each other, a light blocking member 220 disposed on a common electrode panel 200 may be omitted.

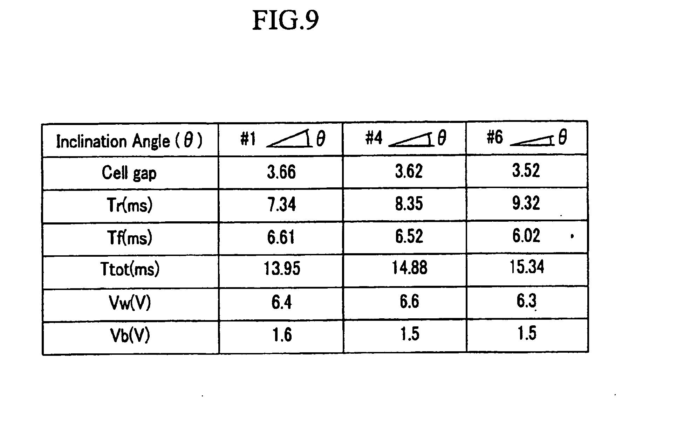

The response time Ttot of liquid crystal was measured for slope members having inclination angles of 1.9°, 1.8°, and 1.1°, which is illustrated as a table shown in Fig. 9. The response time Ttot of the liquid crystal includes a rising time Tr and a falling time Tf. The rising time Tr is the time for the LC molecules in absence of an electric field to respond to an electric field generated by applying a maximum voltage Vw to a pixel electrode. The falling time Tf is the time for the LC molecules subjected to the maximum electric field to return to their initial states after applying a minimum voltage Vb to the pixel electrode.

In the table shown in Fig. 9, "Cell gap" indicates the thickness of the LC layer 3, i.e., the distance between the panels 100 and 200.

As shown in Fig. 9, the measured response times are equal to 13.95ms, 14.88ms, and 15.34ms, which are lower than 16ms, while the response time for a conventional LCD without a slope member is about 21ms to about 25ms. In addition, the rising time Tr and the response time Ttot are reduced as the inclination angle of the slope member increases. The measured response times lower than 16ms enable the realization of motion images since it is required to display 60 frames of images in one second for motion images.

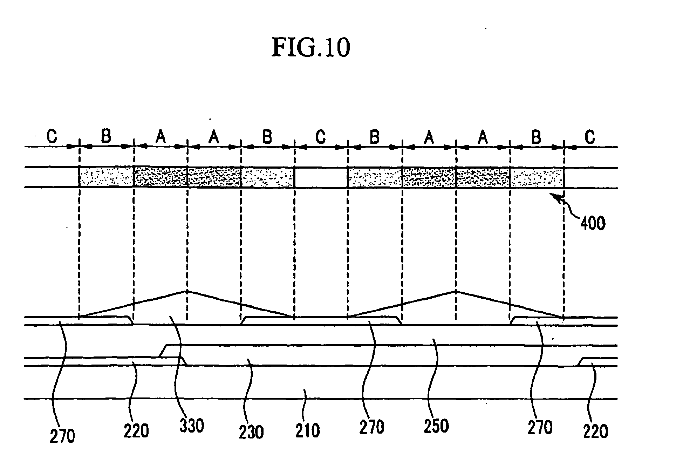

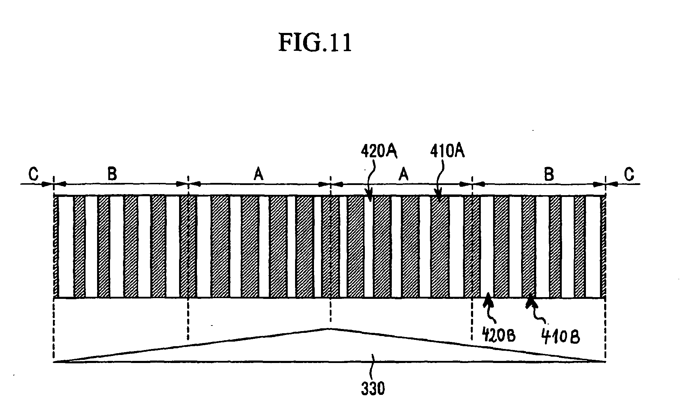

A manufacturing method of a common electrode panel including slope members according to an embodiment of the present invention will be described with reference to Figs. 10 and 11.

Fig. 10 is a sectional view of a common electrode panel and a mask for forming slope members in an intermediate step of a manufacturing method according to an embodiment of the present invention. Fig. 11 illustrates slits of the mask aligned with a slope member.

Referring to Fig. 10, a light blocking member 220, a plurality of color filters 230, and an overcoat 250 are formed in sequence on an insulating substrate 210. The light blocking member 220 may comprise an organic material containing a black pigment, Cr or Cr oxide. The overcoat 250 may comprise an inorganic or organic insulator. The color filters 230 may be formed, for example, by sequentially coating, light-exposing, and developing a negative photosensitive organic material containing red, green, and blue pigments. Subsequently, an ITO or IZO layer is deposited on the overcoat 250 and pattern to form a common electrode 270 having a plurality of cutouts 70. According to an embodiment of the present invention, the cutouts 70 may be omitted.

Next, a photosensitive organic insulating layer is coated on the common electrode 270, and is subjected to light exposure through a mask 400. Then, the photosensitive organic insulating layer is developed to form a plurality of slope members 330. The mask 400 includes light transmitting areas C substantially transmitting incident light and translucent areas A and B partially transmitting incident light. The translucent areas A and B face the slope members 330.

Referring to Fig. 11, the translucent areas A and B include a plurality of light blocking members 410A, 410B spaced apart from each other to define a plurality of slits 420A, 420B therebetween. The width of the slits 420A, 420B and the distance between the slits 420A, 420B may be smaller than a resolution of an exposer used in the light exposure. The light transmittance of the translucent areas A and B gradually increases from a center to edges of the translucent areas A and B. For example, in a translucent area A, the width of the light blocking members 410A is fixed an may be in a range of about 1.0 microns to about 2.5 microns, and the width of the slits 420A gradually increases from a center to both edges of the translucent area A. In a translucent area B, the width of the slits 420B is fixed and may be in a range of about 1.0 microns to about 2.5 microns, and the width of the light blocking members 410B gradually decreases from a center to both edges of the translucent area B. The light blocking areas may include the light blocking members 410A, 410B having widths larger than a predetermined value.

According to an embodiment of the present invention, a uniform inclination angle θ of the slope members 330 can be formed and a uniform and reproducible manufacturing process can be performed. The thickness of the slope members 330 may have a maximum value of about 1.5 microns. The inclination angle of the slope members 330 may be in a range of about 1.2to about 3.0 degrees. The width of the slope members 330 can be varied depending on the width of domains.

Methods according to embodiments of the present invention are applicable to form slope members on a TFT array panel 100.

The slope members can be applicable to any type of LCDs such as twisted nematic (TN) type LCDs or in-plane switching (IPS) type LCDs.

In addition, the mask is applicable to pattern other layers having slanted edge profiles or to form contact holes having smooth sidewalls.

Although preferred embodiments have been described herein with reference to the accompanying drawings, it is to be understood that the present invention is not limited to these precise embodiments but various changes and modifications can be made by one skilled in the art without departing from the the scope of the invention as defined by the appended claims.

## Claims

1. A mask (400) for use in manufacturing a liquid crystal display, the mask comprising an exposure area having a transmittance that gradually increases along a predetermined direction, wherein the exposure area comprises:
a first area (A) including first light blocking members (410A) having a uniform width, wherein the first light blocking members define first slits (420A) and the width of the first slits increases along the predetermined direction; and
a second area (B) including second light blocking members (410B) that define second slits (420B) wherein the second slits have a uniform width and the width of the second light blocking members decreases along the predetermined direction.

2. The mask of claim 1, wherein the width of the second light blocking members (410B) decreases as the second light blocking members are further away from the first area (A).

3. The mask of claim 1, wherein each of the first light blocking members (410A) and each of the second slits (420B) has a width in a range from about 1.0 microns to about 2.5 microns.

4. A method of manufacturing a liquid crystal display, the method comprising:
depositing an insulating layer on a first substrate (110 or 210);
aligning the first substrate with a mask (400) having a transmittance that gradually increases along a predetermined direction, wherein the exposure area comprises a first area (A) including first light blocking members (410A) having a uniform width, wherein the first light blocking members define first slits (420A) and the width of the first slits increases along the predetermined direction; and
a second area (8) including second light blocking members (4108) that define second slits (420B), wherein the second slits have a uniform width and the width of the second light blocking members decreases along the predetermined direction; and
forming a slope member (330) by patterning the insulating layer with lithography using the mask.

5. The method of claim 4, wherein the insulating layer has photosensitivity.

6. The method of claim 4, wherein the width of the second light blocking members (420B) decreases as the second light blocking members are further away from the first area (A).

7. The method of claim 4, wherein each of the first light blocking members (410A) and each of the second slits (420B) has a width ranging from about 1.0 microns to about 2.5 microns.

8. The method of claim 4, wherein the slope member (330) has a flat inclined surface having a single gradient.

9. The method of claim 4, further comprising:
forming a gate line (121), a data line (171), a thin film transistor, and a pixel electrode (190) on the first substrate (110) before forming the slope member thereon.

10. The method of claim 9, wherein the pixel electrode (190) includes a cutout (92a, 92b).

11. The method of claim 4, further comprising:
forming a common electrode (270) on the first substrate (210) before forming the slope member (330) thereon. .

12. The method of claim 11, wherein the common electrode (270) includes a cutout (71, 72b).

13. The method of claim 9, further comprising forming a common electrode (270) on a second substrate (210).

14. The method of claim 13, wherein the common electrode (270) includes a cutout (71, 72a, 72b).

15. The method of claim 14, wherein the slope member (330) is extended to a position corresponding to the cutout (71, 72a, 72b) of the common electrode.

16. The method of claim 11, further comprising:
forming a pixel electrode (190) on a second substrate (110).

17. The method of claim 16, wherein the pixel electrodes includes a cutout (92a, 92b).

18. The method of claim 17, wherein the slope member (330) is extended to a position corresponding to the cutout of the pixel electrode.

## Patentansprüche

1. Maske (400) zur Verwendung bei der Herstellung einer Flüssigkristallanzeige, wobei die Maske einen Belichtungsbereich umfasst, der ein Transmissionsvermögen aufweist, das entlang einer bestimmten Richtung graduell zunimmt, wobei der Belichtungsbereich umfasst:
einen ersten Bereich (A), der erste Lichtabschirmelemente (410A) mit einer gleichmäßigen Breite aufweist, wobei die ersten Lichtabschirmelemente erste Schlitze (420A) definieren und die Breite der ersten Schlitze entlang der bestimmten Richtung zunimmt; und
einen zweiten Bereich (B), der zweite Lichtabschirmelemente (410B) aufweist, die zweite Schlitze (420B) definieren, wobei die zweiten Schlitze eine gleichmäßige Breite aufweisen und die Breite der zweiten Lichtabschirmelemente entlang der bestimmten Richtung abnimmt.

2. Maske nach Anspruch 1, wobei die Breite der zweiten Lichtabschirmelemente (410B) mit zunehmender Entfernung der zweiten Lichtabschirmelemente vom ersten Bereich (A) abnimmt.

3. Maske nach Anspruch 1, wobei jedes der ersten Lichtabschirmelemente (410A) und jeder der zweiten Schlitze (420B) eine Breite in einem Bereich von ungefähr 1,0 Mikrometern bis ungefähr 2,5 Mikrometern aufweist.

4. Verfahren zur Herstellung einer Flüssigkristallanzeige, wobei das Verfahren umfasst:
Abscheiden einer Isolierschicht auf einem ersten Substrat (110, oder 210);
Ausrichten des ersten Substrats mit einer Maske (400), die ein Transmissionsvermögen aufweist, das entlang einer bestimmten Richtung graduell zunimmt, wobei der Belichtungsbereich umfasst:
einen ersten Bereich (A), der erste Lichtabschirmelemente (410A) mit einer gleichmäßigen Breite aufweist, wobei die ersten Lichtabschirmelemente erste Schlitze (420A) definieren und die Breite der ersten Schlitze entlang der bestimmten Richtung zunimmt; und
einen zweiten Bereich (B), der zweite Lichtabschirmelemente (410B) aufweist, die zweite Schlitze (420B) definieren, wobei die zweiten Schlitze eine gleichmäßige Breite aufweisen und die Breite der zweiten Lichtabschirmelemente entlang der bestimmten Richtung abnimmt; und Ausbilden eines Flankenelements (330) durch Mustern der Isolierschicht mit Lithographie unter Verwendung der Maske.

5. Verfahren nach Anspruch 4, wobei die Isolierschicht Photosensitivität aufweist.

6. Verfahren nach Anspruch 4, wobei die Breite der zweiten Lichtabschirmelemente (410B) mit zunehmender Entfernung der zweiten Lichtabschirmelemente vom ersten Bereich (A) abnimmt.

7. Verfahren nach Anspruch 4, wobei die ersten Lichtabschirmelemente (41 0A) und jeder der zweiten Schlitze (420B) eine Breite im Bereich von ungefähr 1,0 Mikrometern bis ungefähr 2,5 Mikrometern aufweist.

8. Verfahren nach Anspruch 4, wobei das Flankenelement (330) eine flache geneigte Oberfläche mit einem einzigen Gradienten aufweist.

9. Verfahren nach Anspruch 4, ferner umfassend:
Ausbilden einer Gateleitung (121), einer Datenleitung (171), eines Dünnfilmtransistors und einer Pixelelektrode (190) auf dem ersten Substrat (110), bevor das Flankenelement darauf ausgebildet wird.

10. Verfahren nach Anspruch 9, wobei die Pixelelektrode (190) einen Ausschnitt (92a, 92b) aufweist.

11. Verfahren nach Anspruch 4, ferner umfassend:
Ausbilden einer gemeinsamen Elektrode (270) auf dem ersten Substrat (110), bevor das Flankenelement (330) darauf ausgebildet wird.

12. Verfahren nach Anspruch 11, wobei die gemeinsame Elektrode (270) einen Ausschnitt (71, 72b) aufweist.

13. Verfahren nach Anspruch 9, ferner umfassend eine gemeinsame Elektrode (270) auf einem zweiten Substrat (210).

14. Verfahren nach Anspruch 13, wobei die gemeinsame Elektrode (270) einen Ausschnitt (71, 72a, 72b) aufweist.

15. Verfahren nach Anspruch 14, wobei das Flankenelement (330) zu einer Position verlängert wird, die dem Ausschnitt (71, 72a, 72b) der gemeinsamen Elektrode entspricht.

16. Verfahren nach Anspruch 11, ferner umfassend:
Ausbilden einer Pixelelektrode (190) auf einem zweiten Substrat (110).

17. Verfahren nach Anspruch 16, wobei die Pixelelektrode einen Ausschnitt (92a, 92b) aufweist.

18. Verfahren nach Anspruch 17, wobei das Flankenelement (330) zu einer Position verlängert wird, die dem Ausschnitt der Pixeletektrode entspricht.

## Revendications

1. Masque (400) pour une utilisation dans la fabrication d'un affichage à cristaux liquides, le masque comprenant une zone d'exposition ayant un facteur de transmission qui augmente progressivement le long d'une direction prédéterminée, dans lequel la zone d'exposition comprend :
■ une première zone (A) comprenant des premiers éléments de blocage de la lumière (410A) ayant une largeur uniforme, dans laquelle les premiers éléments de blocage de la lumière définissent des premières fentes (420A) et la largeur des premières fentes augmente le long de la direction prédéterminée ; et
■ une seconde zone (B) comprenant des seconds éléments de blocage de la lumière (410B) qui définissent des secondes fentes (420B), dans laquelle les secondes fentes ont une largeur uniforme et la largeur des seconds éléments de blocage de la lumière diminue le long de la direction prédéterminée.

2. Masque selon la revendication 1, dans lequel la largeur des seconds éléments de blocage de la lumière (410B) diminue lorsque les seconds éléments de blocage de la lumière sont davantage éloignés de la première zone (A).

3. Masque selon la revendication 1, dans lequel chacun des premiers éléments de blocage de la lumière (410A) et chacune des secondes fentes (420B) ont une largeur dans une plage d'environ 1,0 micron à environ 2,5 microns.

4. Procédé de fabrication d'un affichage à cristaux liquides, le procédé comprenant :
■ le dépôt d'une couche isolante sur un premier substrat (110, ou 210) ;
■ l'alignement du premier substrat avec un masque (400) ayant un facteur de transmission qui augmente progressivement le long d'une direction prédéterminée, dans lequel la zone d'exposition comprend une première zone (A) comprenant des premiers éléments de blocage de la lumière (410A) ayant une largeur uniforme, dans laquelle les premiers éléments de blocage de la lumière définissent des premières fentes (420A) et la largeur des premières fentes augmente le long de la direction prédéterminée ; et
**■** une seconde zone (B) comprenant des seconds éléments de blocage de la lumière (410B) qui définissent des secondes fentes (420B), dans laquelle les secondes fentes ont une largeur uniforme et la largeur des seconds éléments de blocage de la lumière diminue le long de la direction prédéterminée ; et
■ la formation d'un élément incliné (330) en formant un motif dans la couche isolante par lithographie en utilisant le masque.

5. Procédé selon la revendication 4, dans lequel la couche isolante présente une photosensibilité.

6. Procédé selon la revendication 4, dans lequel la largeur des seconds éléments de blocage de la lumière (420B) diminue lorsque les seconds éléments de blocage de la lumière sont davantage éloignés de la première zone (A).

7. Procédé selon la revendication 4, dans lequel chacun des premiers éléments de blocage de la lumière (410A) et chacune des secondes fentes (420B) ont une largeur allant d'environ 1,0 micron à environ 2,5 microns.

8. Procédé selon la revendication 4, dans lequel l'élément incliné (330) comporte une surface inclinée plate ayant un seul gradient.

9. Procédé selon la revendication 4, comprenant en outre :
■ la formation d'une ligne de grille (121), d'une ligne de données (171), d'un transistor à film mince et d'une électrode de pixel (190) sur le premier substrat (110) avant d'y former l'élément incliné.

10. Procédé selon la revendication 9, dans lequel l'électrode de pixel (190) comprend un coupe-circuit (92a, 92b).

11. Procédé selon la revendication 4, comprenant en outre :
**■** la formation d'une électrode commune (270) sur le premier substrat (210) avant d'y former l'élément incliné (330).

12. Procédé selon la revendication 11, dans lequel l'électrode commune (270) comprend un coupe-circuit (71, 72b).

13. Procédé selon la revendication 9, comprenant en outre la formation d'une électrode commune (270) sur un second substrat (210).

14. Procédé selon la revendication 13, dans lequel l'électrode commune (270) comprend un coupe-circuit (71, 72a, 72b).

15. Procédé selon la revendication 14, dans lequel l'élément incliné (330) est étendu jusqu'à une position correspondant au coupe-circuit (71, 72a, 72b) de l'électrode commune.

16. Procédé selon la revendication 11, comprenant en outre :
■ la formation d'une électrode de pixel (190) sur un second substrat (110).

17. Procédé selon la revendication 16, dans lequel l'électrode de pixel comprend un coupe-circuit (92a, 92b).

18. Procédé selon la revendication 17, dans lequel l'élément incliné (330) est étendu jusqu'à une position correspondant au coupe-circuit de l'électrode de pixel.
